# EUROPEAN PATENT APPLICATION

(11) **EP 1 684 361 A2**
(43) Date of publication of application: **26.07.2006**
(21) Application number: 05028082.5
(22) Date of filing: 21.12.2005
(51) Int. Cl.: H01L 31/05

(54) **Lead structure**

(30) Priority: 24.01.2005 JP 2005015213
(71) Applicant: Toyama Machineries Co., Ltd., Chuo-ku Osaka-shi Osaka 540-0017 (JP)
(72) Inventor: Toyama, Toshio, Sakai-shi Osaka 599-8126 (JP)
(74) Representative: Schubert, Siegmar

(57) **Abstract**

In a lead (1) to be welded through solder to a pass-bar of a solar battery cell, a plurality of through holes (2) having corners (2a) in the lateral direction of the lead are formed along its longitudinal direction. Consequently, when the lead is disposed on a pass-bar of a solar battery cell and heated, the lead (1) and the solar battery cell are subjected to thermal expansion, In such case, due to expansion of the lead (1), stress acts intensively on the corner tip of each through hole. The intensive stress creates a plastic region in the vicinity of the corner tip. Therefore, when the lead (1) is welded to a pass-bar of a solar battery cell and cooled, the lead is inhibited from contracting by the the amount equivalent to the amount of expansion caused by heating due to creation of the plastic region, and bending and thermal stress that acts on the solar battery cell is mitigated.

## Description

### BACKGROUND OF THE INVENTION

This application claims priority on Patent Application No. 2005-15213 filed in Japan on January 24, 2005, the entire contents of which are hereby incorporated by reference.

The present invention relates to a structure of a lead welded to a solar battery cell.

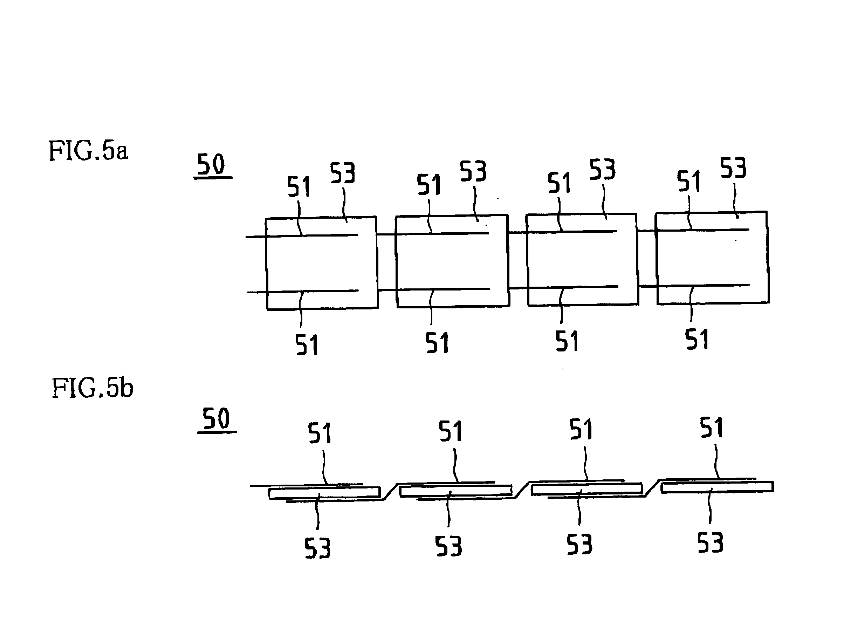

In general, a solar battery module is manufactured by first forming a string of solar battery cells by connecting a plurality of solar battery cells, and then connecting a plurality of strings so as to be formed in a sheet form. In this case, when a string is formed by connecting a plurality of solar battery cells, adjacent solar battery cells are connected via a square-shaped lead that is made of a conductive material and has a flat cross section. Concretely, as shown in FIG.5a and FIG.5b, while one half portion of a lead 51 is welded through solder to a pass-bar formed on a surface of a solar battery cell 53, the other half portion of the lead 51 that is welded to the solar battery cell 53 is welded through solder to a pass-bar formed on a back face of another solar battery cell 53 that is adjacent thereto to connect in sequence a plurality of solar battery cells 53, thereby forming a string 50.

In order to weld a lead to a solar battery cell automatically and successively in the manner described above, a welding apparatus is proposed with which a solar battery cell is positioned on a toothed belt and conveyed to a welding position, the right and left end portions of the solar battery cell protruding from the right and left edges of the toothed belt are supported by a heat control block, then respective leads are transported to pass-bars of solar battery cells and placed on the pass-bars, and the leads so placed are heated after pressed against the solar battery cells to be welded to the pass-bars of the solar battery cells (e.g. JP2004-39856A).

Incidentally, when a lead is welded to a solar battery cell as described above, a solar battery cell and a lead are cooled after heat is applied and a lead is welded through solder to a bass-bar of a solar battery cell. Here, the coefficient of linear expansion of a lead, copper for example, is 16 × 10⁻⁶ (/°C), whereas the coefficient of linear expansion of a solar battery cell, i.e. silicon, is 7.6 × 10⁻⁶ (/°C). Therefore, when a solar battery cell and a lead are cooled after they are heated and welded through solder to each other, the solar battery cell and the lead tend to contract by the amount of their respective expansion so that they are subjected to bending and thermal stress. Since a solar battery cell is fragile and thin with a thickness of 0.3 to 0.5mm, cracking tends to occur due to bending and thermal stress. Even if cracking does not occur, it is possible that a solar battery cell is curved due to bending, creating a residual strain to a solar battery cell, which causes various problems in a subsequent process. Especially in recent years, since the thickness of a solar battery cell has been made thinner to 0.15 to 0.2mm, a solar battery cell cannot resist even a slight bending and thermal stress, increasing occurrence of cracking, and resulting in a lower yield.

As a solution to the problems of above-described Prior Art, lead manufacturers have been adopted a hybrid structure in which various different materials for a conductive material of a lead are laminated, and have been developing materials that approximate the coefficient of linear expansion of leads to that of solar battery cells.

### SUMMARY OF THE INVENTION

The present invention has been achieved in consideration of these issues, and it is an object thereof to provide a lead structure that can reduce occurrence of cracking due to bending and thermal stress on the solar battery cell without impairing the conductivity of the lead.

The present invention is characterized in that in a lead to be welded through solder to a pass-bar of a solar battery cell, a plurality of through holes having corners in the lateral direction of the lead are formed along its longitudinal direction.

According to the present invention, a lead and a solar battery cell are subjected to thermal expansion when the lead is disposed on the pass-bar of the solar battery cell and heated. In such case, since a plurality of through holes having corners in the lateral direction of the lead are formed in the lead along its longitudinal direction, due to expansion of the lead, stress acts intensively on the corner tip of each through hole. The intensive stress creates a plastic region in the vicinity of the corner tip. Consequently, when the lead is welded through solder to the pass-bar of the solar battery cell and cooled, the lead is inhibited from contracting by the amount equivalent to the amount of expansion caused by heating due to creation of the plastic region.

As a result, while there occurs no change in the conductivity of the lead, bending and thermal stress that acts on the solar battery cell can be mitigated, thereby reducing occurrence of cracking of the solar battery cell.

The present invention is characterized in that in a lead to be welded through solder to a pass-bar of a solar battery cell, a plurality of notches are formed in the lead along its longitudinal direction.

According to the present invention, a lead and a solar battery cell are subjected to thermal expansion when the lead is disposed on the pass-bar of the solar battery cell and heated. In such case, since a plurality of notches are formed in the lead along its longitudinal direction, due to expansion of the lead, stress acts intensively on the tip of each notch. The intensive stress creates a plastic region in the vicinity of the tip of notches. Consequently, when the lead is welded through solder to the pass-bar of the solar battery cell and cooled, the lead is inhibited from contracting by the amount equivalent to the amount of expansion caused by heating due to creation of the plastic region.

As a result, while there occurs no change in the conductivity of the lead, bending and thermal stress that acts on a solar battery cell can be mitigated, thereby reducing occurrence of cracking of the solar battery cell.

### BRIEF DESCRIPTION OF THE DRAWINGS

FIG. 1 is a plan view showing an embodiment of a lead structure of the present invention.

FIG. 2 is a plan view showing another embodiment of a lead structure of the present invention.

FIG. 3 is a plan view showing a modified example of the lead structure of FIG. 1.

FIG. 4 is a plan view showing still another embodiment of a lead structure of the present invention.

FIG. 5a is a plan view of a string manufactured by connecting a plurality of solar battery cells via leads.

FIG. 5b is a side view of a string manufactured by connecting a plurality of solar battery cells via leads.

### DESCRIPTION OF THE PREFERRED EMBODIMENTS

Hereinafter, embodiments of the present invention will be described in detail with reference to the accompanying drawings.

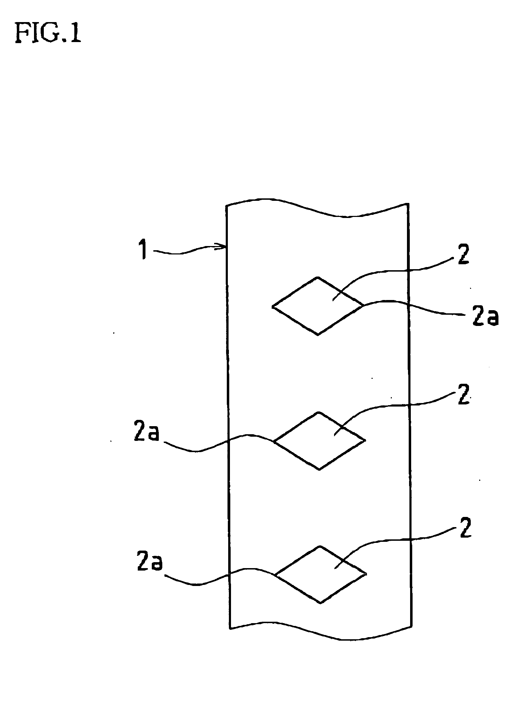

FIGS. 1 through 4 show embodiments of a lead 1 of the present invention respectively.

The lead 1 is formed in square shape having a flat cross section using a conductive material such as copper or copper alloy Rhombic-shaped through holes 2 are formed on the lead 1 in its longitudinal direction at predetermined preset intervals.

When the lead 1 is heated and subjected to thermal expansion in order to weld through solder such lead 1 to a pass-bar of a solar battery cell, stress intensively acts on the tip of a corner 2a of each rhombic-shaped through hole 2 that extends in the lateral direction of the lead 1. The intensive stress creates a plastic region in the vicinity of the tip of the corner 2a. When such lead 1 is welded through solder to the pass-bar of the solar battery cell and cooled, the lead 1 is inhibited from contracting by the amount equivalent to the amount of expansion caused by heating due to creation of the plastic region.

Consequently, since the contraction amount of the lead 1 is smaller than the expansion amount caused by heating, bending and thermal stress that acts on the solar battery cell can be mitigated, thereby reducing occurrence of cracking of the solar battery cell.

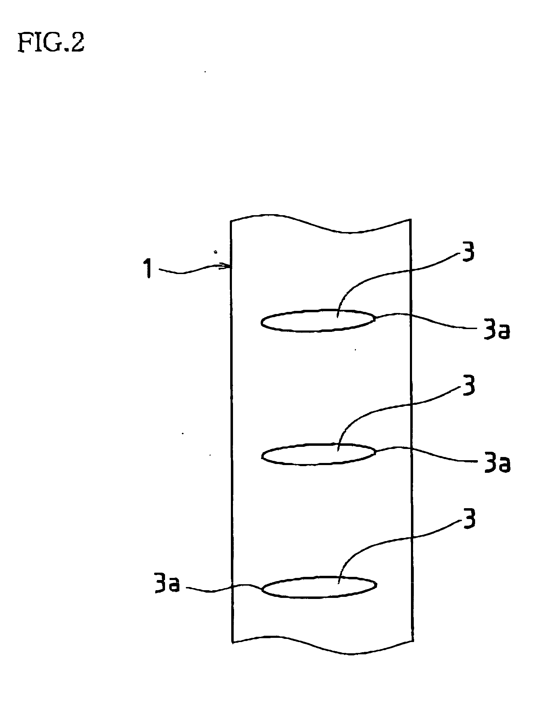

It should be noted that although a case in which rhombic-shaped through holes 2 are formed is explained in the above-described embodiment, the corner may be R-shaped split the radius of whose tip is extremely small. For example, as shown in FIG.2, it is possible to form oval-shaped through holes 3 that have splits 3a in the lateral direction.

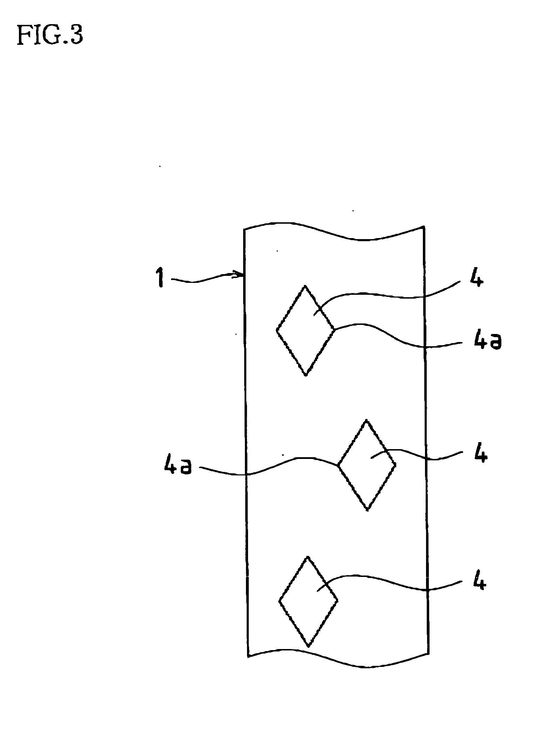

Furthermore, as shown in FIG.3, it is possible to form in two rows rhombic-shaped through holes 4 having corners 4a in the lateral direction in a zigzag form.

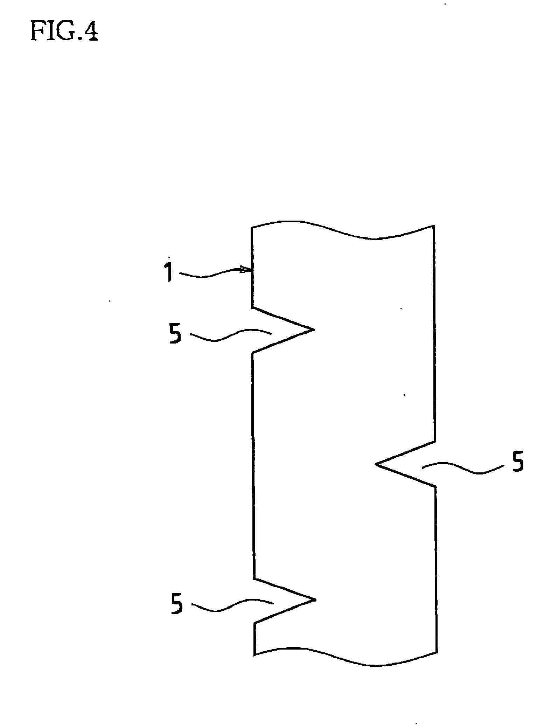

Furthermore, as shown in FIG.4, it is possible to form V-shaped notches 5 instead of the through holes. In the embodiment shown in FIG.4, notches 5 along lateral direction of the lead are formed along its longitudinal direction in a zigzag form.

Furthermore, it is possible to form notches 5 in various shapes such as notches along lateral direction of the lead.

In the same as above-described embodiments, due to notches 5, stress acts intensively on the corner tip of each notch. The intensive stress creates a plastic region in the vicinity of the corner tip. Consequently, when the lead is welded through solder to the pass-bar of the solar battery cell and cooled, the lead is inhibited from contracting by the amount equivalent to the amount of expansion caused by heating due to creation of the plastic region.

As described above, according to the embodiments of the present invention, by performing simple processing such as providing through holes 2,3 or notches 5 to a lead, it is possible to reduce occurrence of cracking of a solar battery cell caused by bending or thermal stress when a string of solar battery cells is manufactured by welding leads 1 to solar battery cells, thereby enabling significant cost reduction of the solar power generation device.

The present invention can be embodied and practiced in other different forms without departing from the spirit and essential characteristics thereof. Therefore, the above-described embodiments are considered in all respects as illustrative and not restrictive. The scope of the invention is indicated by the appended claims rather than by the foregoing description. All variations and modifications falling within the equivalency range of the appended claims are intended to be embraced therein.

## Claims

1. A lead structure comprising a lead to be welded through solder to a pass-bar of a solar battery cell,
wherein a plurality of through holes having corners in a lateral direction of the lead are formed along its longitudinal direction.

2. A lead structure comprising a lead to be welded through solder to a pass-bar of a solar battery cell,
wherein a plurality of notches are formed in the lead along its longitudinal direction
